(19) Europäisches Patentamt / European Patent Office / Office européen des brevets

(11) **EP 2 290 767 B1**

(12) **FASCICULE DE BREVET EUROPEEN**

(45) Date de publication et mention
de la délivrance du brevet:
**09.05.2012 Bulletin 2012/19**

(51) Int Cl.:
*H01S 5/12* *(2006.01)*    *H01S 5/062* *(2006.01)*
*H01S 5/10* *(2006.01)*    *H01S 5/14* *(2006.01)*

(21) Numéro de dépôt: **10172313.8**

(22) Date de dépôt: **09.08.2010**

(54) **Laser semi-conducteur à modulation électrique**

Elektrisch modulierter Halbleiterlaser

Electrically modulated semiconductor laser

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **28.08.2009 FR 0904104**

(43) Date de publication de la demande:
**02.03.2011 Bulletin 2011/09**

(73) Titulaire: **Thales**
**92200 Neuilly Sur Seine (FR)**

(72) Inventeur: **Van Dijk, Frédéric**
**91400, ORSAY (FR)**

(74) Mandataire: **Henriot, Marie-Pierre et al**
**Marks & Clerk France**
**Conseils en Propriété Industrielle**
**Immeuble Visium**
**22, Avenue Aristide Briand**
**94117 Arcueil Cedex (FR)**

(56) Documents cités:
**EP-A2- 0 516 263**    **EP-A2- 1 146 616**
**US-A- 5 082 799**

- **GOUTAIN E ET AL: "30 GHz bandwidth, 1.55 [micro]m MQW-DFB laser diode based on a new modulation scheme" ELECTRONICS LETTERS, IEE STEVENAGE, GB, vol. 32, no. 10, 9 mai 1996 (1996-05-09), pages 896-897, XP006005100 ISSN: 0013-5194**
- **LAU K Y: "EFFICIENT NARROW-BAND DIRECT MODULATION OF SEMICONDUCTOR INJECTION LASERS AT MILLIMETER WAVE FREQUENCIES OF 100 GHZ AND BEYOND" APPLIED PHYSICS LETTERS, AIP, AMERICAN INSTITUTE OF PHYSICS, MELVILLE, NY, US, vol. 52, no. 26, 27 juin 1988 (1988-06-27), pages 2214-2216, XP000020113 ISSN: 0003-6951**
- **BIERNACKI P ET AL: "Impedance matching of laser diodes using packaged microstrip lines: active and passive" LASERS AND ELECTRO-OPTICS SOCIETY ANNUAL MEETING, 1995. 8TH ANNUAL MEE TING CONFERENCE PROCEEDINGS, VOLUME 1., IEEE SAN FRANCISCO, CA, USA 30-31 OCT. 1995, NEW YORK, NY, USA,IEEE, US, vol. 1, 30 octobre 1995 (1995-10-30), pages 238-239, XP010153472 ISBN: 978-0-7803-2450-3**

**Description**

Le domaine de l'invention est celui des diodes lasers à semi-conducteur dont le faisceau laser est modulé notamment à une haute fréquence en vue d'applications aux télécommunications à très haut débit, aux systèmes radars, etc.

Il est connu de moduler le faisceau laser émis en continu par un laser semi-conducteur en ajoutant un modulateur à la sortie du laser. Il s'agit alors d'un modulateur externe au laser comme par exemple un modulateur mécanique.

Mais la solution la plus couramment mise en oeuvre consiste à réaliser une modulation électro-optique directe du laser.

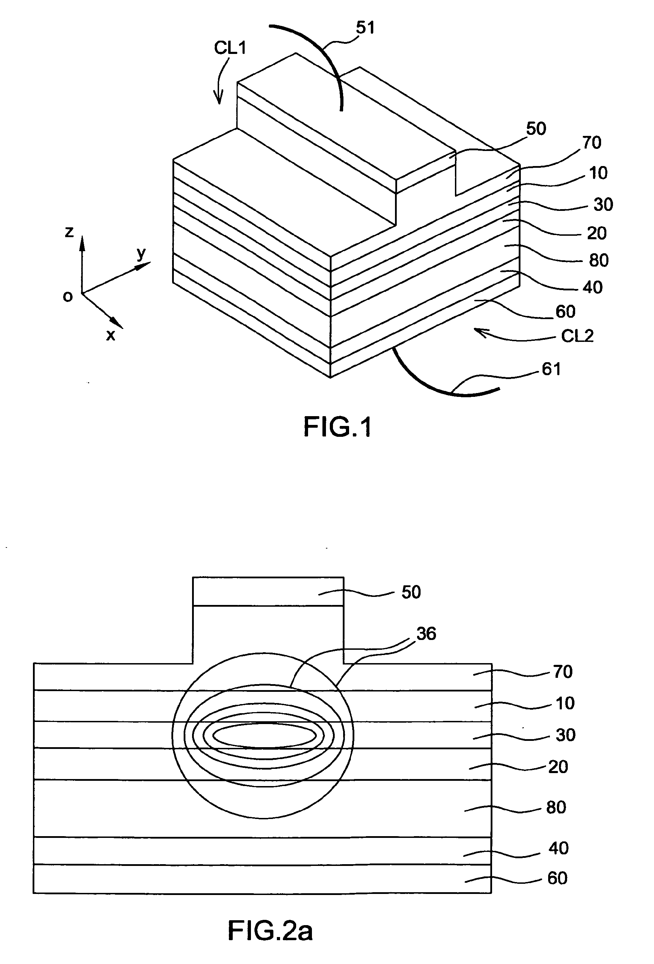

On rappelle que dans une diode laser à semi-conducteur décrite en relation avec la figure 1, la cavité optique comprend une partie active 30 où l'injection électrique permet d'obtenir du gain optique, formée sur une couche guidante inférieure 20. Une couche guidante supérieure 10 est formée sur la partie active 30. Au dessus de la couche guidante supérieure 10 une couche de confinement 70, d'indice de réfraction inférieur à la couche guidante supérieure 10 assure le confinement de l'onde optique sur la partie supérieure du guide d'onde optique. Au dessous de la couche guidante inférieure 20, une couche de confinement 80, d'indice de réfraction inférieur à la couche guidante inférieure 20 assure le confinement de l'onde optique sur la partie inférieure du guide d'onde optique ; cette couche 80 est déposée sur un substrat 40. Ces couches sont selon un plan Oxy.

L'empilement selon l'axe Oz, des couches 70, 20, 30, 10, 80, du fait de leurs indices permet ainsi le confinement vertical de l'onde optique pour former le guide optique. Le confinement latéral de l'onde optique est obtenu grâce à une différence d'indice optique vu par l'onde optique, tel que l'indice optique vu au milieu du semi-conducteur, lieu de propagation de l'onde optique, est supérieur à l'indice optique vu par l'onde sur les côtés du guide d'onde optique. On obtient ainsi le confinement latéral du guide d'onde optique.

La cavité optique est donc obtenue par le guide d'onde optique tel que décrit plus haut et deux réflecteurs optiques qui vont réfléchir l'onde optique. La longueur Lo de la cavité repérée selon la direction de propagation de l'onde optique, en l'occurrence la direction Ox est égale à la distance entre ces deux réflecteurs. Le faisceau laser est émis par la tranche (selon Oyz), par une des deux extrémités de la cavité optique.

Les miroirs (ou réflecteurs) de la cavité optique peuvent résulter du simple fait de cliver le semi-conducteur, de fort indice optique, ce qui permet d'obtenir un coefficient de réflexion suffisant pour assurer une fonction de miroir ; les deux faces clivées CL1, CL2 (selon Oyz) du semi-conducteur peuvent assurer la fonction de miroirs optiques. Les miroirs optiques peuvent également être obtenus par l'intégration monolithique d'un miroir de Bragg ou d'un miroir à cristal photonique intégrés dans le matériau semi-conducteur.

Les diodes lasers à semi-conducteur sont particulièrement compactes. Elles ont typiquement une longueur selon Ox de 100 à 5000 $\mu$m, une largeur selon Oy comprise entre 200 et 500 $\mu$m et la couche active a une épaisseur selon Oz entre 0,1 et 2 $\mu$m. Le faisceau laser est émis par une petite surface de la tranche selon Oyz, qui mesure typiquement moins de 20 $\mu$m de côté.

Le pompage électrique de la partie active (ou milieu amplificateur) se fait à l'aide d'un courant électrique continu issu d'un circuit d'alimentation, qui enrichit ce milieu amplificateur en trous d'un côté et en électrons de l'autre. La lumière est produite au niveau de la jonction par la recombinaison des trous et des électrons. Le circuit d'alimentation est connecté au semi-conducteur via :

- un fil électrique d'alimentation 51 relié à une première électrode 50 dite électrode supérieure, au contact de la couche de confinement supérieure 70 et
- un fil électrique d'alimentation 61 relié à une deuxième électrode souvent désignée plan de masse 60 au contact de la couche de confinement inférieure 80 à travers le substrat 40 ; ce plan de masse couvre généralement (mais pas toujours) toute la surface de la face inférieure du semi-conducteur.

L'électrode supérieure 50 est par exemple positive avec une couche guidante supérieure 10 de type p, le plan de masse 60 étant alors négatif avec une couche guidante inférieure 20 de type n. La configuration inverse est possible, avec une électrode supérieure et une couche guidante supérieure négatives d'une part et une couche guidante inférieure et un plan de masse positifs d'autre part.

Dans ce type de diode laser, la modulation électro-optique directe consiste à moduler le signal électrique de pompage de la cavité optique à une fréquence Fe. Ce signal modulé vient se superposer au signal continu de pompage.

Mais cette modulation électro-optique directe d'une diode laser à semi-conducteur à haute fréquence est limitée par la réponse intrinsèque du milieu à gain (milieu amplificateur), par les éléments parasites dégradant la réponse électrique (capacité, résistance série...).

Pour améliorer l'efficacité de modulation, il est possible de jouer sur des résonances apportées par le circuit d'alimentation. Il est par exemple possible de réaliser une adaptation d'impédance réactive à cet effet comme décrit dans les publications « Monolithic integration of optoelectronic devices with reactive matching networks for microwave applications », Maricot, S.; Vilcot, J.P.; Decoster, D.; Renaud, J.C.; Rondi, D.; Hirtz, P.; Blondeau, R.; de Cremoux, B.; IEEE Photonics Technology Letters, Volume 4, Issue 11, Nov. 1992 Page(s):1248 - 1250 ; « Broad-band reactive matching of high-speed directly modulated laser diodes » Goldsmith, C.L.; Kanack, B.; IEEE Microwave and Guided Wave Letters, Volume 3, Issue 9, Sept. 1993 Page(s):336 - 338.

Il existe deux manières de réaliser cette adaptation d'impédance :

- soit par un circuit externe au dispositif. Il est alors nécessaire d'ajuster précisément les caractéristiques des différents éléments en fonction de la géométrie de la diode laser à semi-conducteur mais également des caractéristiques de montage de la diode laser à semi-conducteur, qui ne sont pas toujours reproductibles. Cette solution peut s'avérer difficile, notamment à haute fréquence c'est-à-dire pour une fréquence F > 5 GHz.
- soit par un circuit intégré de façon monolithique. Dans ce dernier cas la fabrication est considérablement alourdie avec l'intégration monolithique de selfs et de capacités.

L'inconvénient de cette solution basée sur l'adaptation d'impédance réside dans la complexité de son implémentation.

On sait aussi procéder à une amélioration de la réponse électro-optique à une fréquence donnée (pour obtenir une modulation bande étroite), en fixant la longueur de la cavité laser de manière à avoir une résonance dans la cavité optique identique à la fréquence de modulation visée, soit celle du signal électrique de pompage. On obtient ainsi une amélioration très importante de la fréquence de modulation : des fréquences d'environ 100 GHz sont atteintes. Ce phénomène a été décrit par une équipe de l'Université de Santa-Barbara [Nagarajan, R.; Levy, S.; Mar, A.; Bowers, J.E.; IEEE - PTL, Vol. 5, Issue 1, Jan. 1993 Page(s):4 - 6]. Il est notamment utilisé dans le verrouillage d'un laser mode-locké à semi-conducteur sur un oscillateur externe tel qu'un synthétiseur, comme proposé dans la publication « Narrow-band modulation of semiconductor lasers at millimeter wave frequencies (>100 GHz) by mode locking » Lau, K.Y.; IEEE Journal of Quantum Electronics, Volume 26, Issue 2, Feb. 1990 Page(s):250 - 261. Mais cette technique ne présente pas un rendement de modulation suffisant: il est en effet de l'ordre de -30 dB.

Le but de l'invention est de concevoir une diode laser simple à réaliser et apte à émettre un faisceau laser haute fréquence avec un rendement de modulation satisfaisant.

La solution apportée par l'invention permet d'améliorer l'efficacité de modulation à haute fréquence d'une cavité laser. Elle consiste à adapter la géométrie de l'électrode d'alimentation de manière à générer un résonateur électrique dont la fréquence de résonance est identique à la fréquence de résonance de la cavité optique ou à un multiple de cette résonance.

Plus précisément l'invention a pour objet une diode laser à semi-conducteur à modulation électrique directe qui comprend une cavité optique de longueur Lo et un circuit d'alimentation comportant une électrode d'alimentation modulée en forme de ruban de longueur Lé qui recouvre tout ou partie de la cavité optique, et qui contribue à délivrer un signal électrique de pompage de la cavité optique à une fréquence de modulation Fe. Elle est principalement caractérisée en ce qu'elle comprend une cavité électrique de longueur Lé associée à cette électrode, telle que $n_o.Lo = k.n_é.Lé$, k étant égal à 1, ou 2, ou 3, ou ..., ou ½, ou 1/3, ou ..., (k étant un entier positif ou l'inverse d'un entier positif) $n_o$ étant l'indice de groupe optique de la cavité optique et $n_é$ l'indice électrique de la cavité électrique, et en ce que $Fe = c.k'/(2.n_é.Lé)$, c étant la vitesse de la lumière dans le vide, k' étant égal à 1, ou 2, ou 3, ou ....

Cette configuration de diode laser permet d'augmenter significativement le rendement de modulation électro-optique à la fréquence Fe et ainsi d'obtenir une diode laser capable d'émettre un faisceau laser à haute fréquence, par exemple à une fréquence comprise entre 10 et 100 GHz.

On peut avoir Lé < Lo ou Lé>Lo.

Selon un mode de réalisation particulier, la cavité optique comprend une section externe au semi-conducteur.

Elle comprend éventuellement une deuxième électrode électriquement séparée de la première électrode, pour le pompage électrique de la section de cavité optique non pompée par la première électrode.

Selon une caractéristique de l'invention, un miroir optique et un réflecteur électrique sont situés dans un même plan, l'autre miroir optique et l'autre réflecteur électrique étant situés dans des plans distincts.

D'autres caractéristiques et avantages de l'invention apparaîtront à la lecture de la description détaillée qui suit, faite à titre d'exemple non limitatif et en référence aux dessins annexés dans lesquels :

la figure 1 déjà décrite représente schématiquement un exemple de diode laser à semi-conducteur selon l'état de la technique,

les figures 2 représentent schématiquement vus des tranches du semi-conducteur, les profils du champ optique (fig 2a) et les lignes de champ électrique (fig 2b) d'un laser semi-conducteur selon l'invention,

les figures 3 représentent schématiquement vues de dessus (fig 3a), les cavités optique et électrique d'un laser semi-conducteur selon un premier mode de réalisation de l'invention avec Lé>Lo, correspondant à une diode laser schématiquement représentée vue en perspective qui montre une électrode rectiligne (fig 3b),

les figures 4 représentent schématiquement une variante du premier mode de réalisation avec une électrode courbée selon le plan des couches du semi-conducteur, correspondant à une diode laser schématiquement représentée vue de dessus (fig 4a) et en perspective (fig 4b),

les figures 5 représentent schématiquement vues de dessus (fig 5a) les cavités optique et électrique d'une diode laser à semi-conducteur selon un deuxième mode de réalisation de l'invention avec Lé<Lo correspondant à une diode laser schématiquement représentée vue en perspective (fig 5b) qui montre une électrode en deux parties distinctes,

les figures 6 représentent schématiquement une variante du deuxième mode de réalisation avec une cavité optique externe (fig 6a) correspondant à une diode laser schématiquement représentée vue en perspective (fig 6b) avec une seule électrode.

D'une figure à l'autre, les mêmes éléments sont repérés par les mêmes références.

Pour former une diode laser on doit réaliser une cavité optique qui comprend notamment deux réflecteurs optiques, comme décrit dans le préambule. La figure 2a montre le profil du champ optique 36 dans ce type de guide d'onde optique vu d'une des tranches, selon Oyz. Il est particulièrement intense dans la couche active 30 et diminue au fur et à mesure qu'on s'éloigne de cette couche active 30.

La solution proposée est basée sur la géométrie de la cavité optique et sur celle de la cavité électrique associée à l'électrode supérieure 50 d'alimentation de la cavité optique, associée plus précisément à l'électrode 50 supérieure de modulation.

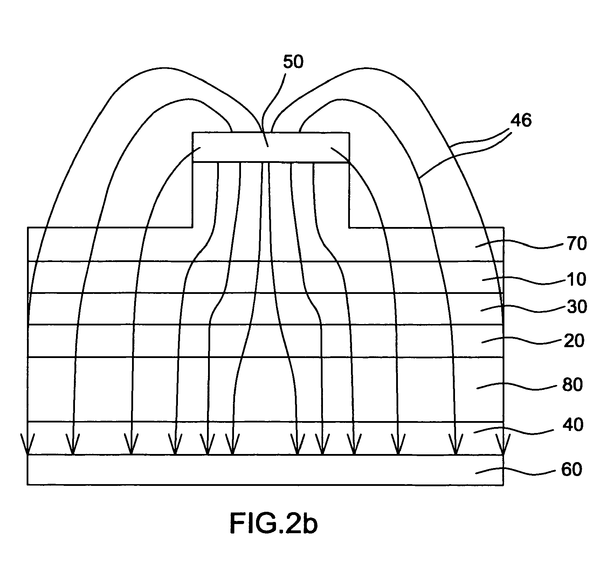

Cette électrode supérieure 50 de modulation génère avec le plan de masse 60 et les couches intermédiaires du semi-conducteur, une ligne électrique, de type ligne micro-ruban à laquelle est associée une cavité électrique. La structure verticale, avec une électrode (par exemple en forme de ligne) déposée sur le semi-conducteur, sous lequel se trouve un plan de masse, peut être considérée comme une ligne microbande et va donc se comporter comme un guide d'onde électrique. La figure 2b montre les lignes de champ électrique 46 du mode TEM qui se propage. Ce guide d'onde va assurer le confinement vertical et latéral de l'onde électrique. Un réflecteur électrique est une surface présentant selon la direction de propagation de l'onde électrique, en l'occurrence Ox, une discontinuité de l'impédance électrique telle que l'onde électrique est réfléchie par cette surface. La cavité électrique comprend deux réflecteurs électriques entre lesquels l'onde électrique est réfléchie. La longueur de la cavité électrique est égale à la distance le long de la ligne micro-ruban entre ses deux réflecteurs électriques.

Dans le cas général, les faces clivées du semi-conducteur vont se comporter comme une interruption de ce guide d'onde électrique avec une forte discontinuité d'impédance et donc comme un réflecteur. Cette discontinuité d'impédance peut également être obtenue en supprimant l'électrode supérieure 50 comme on le verra plus loin dans l'un des exemples.

La solution selon l'invention est fondée sur une diode laser à semi-conducteur telle que la longueur de la cavité électrique donne lieu à une fréquence d'oscillation dans cette cavité électrique qui correspond à la fréquence d'oscillation de la cavité optique ou à une de ses harmoniques.

Sur les structures laser la vitesse de propagation de l'onde optique est plus lente que la vitesse de l'onde électrique. Par conséquent il faut que la longueur géométrique de la cavité électrique soit plus importante que celle de la cavité optique pour obtenir une coïncidence des fréquences à la fréquence optique fondamentale.

A la fréquence de résonance électrique Fe de la cavité électrique, on observe une meilleure absorption de l'énergie électrique incidente. Ceci a pour conséquence un meilleur couplage de l'énergie dans la cavité optique (cavité laser) à exciter. On a :

Fe = 1 / temps AR de l'onde électrique dans la cavité électrique, AR désignant l'aller-retour.

A la fréquence de résonance optique Fo de la cavité optique, on observe déjà une amélioration notable de l'efficacité de modulation du laser comme indiqué dans le préambule. On a :

Fo = 1 / temps AR de l'onde optique dans la cavité optique.

Selon l'invention, la mise en coïncidence de ces deux fréquences (Fe=k.Fo) améliore très significativement l'efficacité de modulation du laser à la fréquence de résonance commune. Ceci est obtenu de la manière suivante.

La cavité optique a une longueur Lo égale à la distance entre ses deux réflecteurs optiques. L'électrode supérieure 50 qui assure avec le plan de masse, le pompage électrique modulé de la cavité optique, a la forme d'un ruban de longueur Lé qui couvre tout ou partie de la cavité optique. Cette électrode 50 est associée à une cavité électrique de longueur Lé égale à la distance entre ses deux réflecteurs électriques. Les cavités optique et électrique ont alors une portion commune.

Les longueurs Lé et Lo sont telles que :

$$n_o.Lo = k.n_é.Lé,$$

k étant égal à 1, 2, 3, ..., c'est-à-dire k étant un entier positif pour le cas où la fréquence d'oscillation fondamentale de la cavité électrique est égale à la fréquence fondamentale de la cavité optique ou à son harmonique k, ou telles que :

$$k.n_o.Lo = n_é.Lé,$$

k étant égal à 1, 2, 3, ..., , c'est-à-dire k étant un entier positif pour le cas où la fréquence d'oscillation fondamentale de la cavité optique est égale à la fréquence fondamentale de la cavité électrique ou à son harmonique k,

$n_o$ étant l'indice de réfraction de la cavité optique et $n_é$ l'indice électrique de la cavité électrique.

Finalement on peut écrire :

$$n_o.Lo = k.n_é.Lé,$$

k étant égal à 1, 2, 3, ..., ou ½, 1/3, ¼, ... c'est-à-dire k étant un entier positif ou l'inverse d'un entier positif.

Pour mettre en oeuvre l'invention proposée, plusieurs modes de réalisation sont possibles.

La cavité optique est délimitée sur sa longueur selon Ox, par un premier et un deuxième miroirs optiques 31, 32, qui sont des surfaces réfléchissantes pour l'onde optique. La cavité électrique est délimitée sur sa longueur par un premier et un deuxième réflecteur électrique 41, 42, qui sont des surfaces réfléchissantes pour l'onde électrique. Ces réflecteurs électriques 41, 42 sont induits par les extrémités de l'électrode 50. Ils ont donc la même position repérée selon l'axe de la longueur de l'électrode 50, que les extrémités de l'électrode : ils sont à l'aplomb de ces extrémités. Comme on le verra dans la suite certaines de ces surfaces sont réfléchissantes à la fois pour l'onde optique et pour l'onde électrique comme par exemple dans le cas où la face clivée du semi-conducteur assure cette double fonction ; dans d'autres cas, une surface réfléchissante pour l'onde optique est transparente pour l'onde électrique ou l'inverse.

De préférence pour des raisons de facilité de fabrication, les deux cavités optique et électrique ont une extrémité commune qui est une des faces clivée CL (1 ou 2) du semi-conducteur.

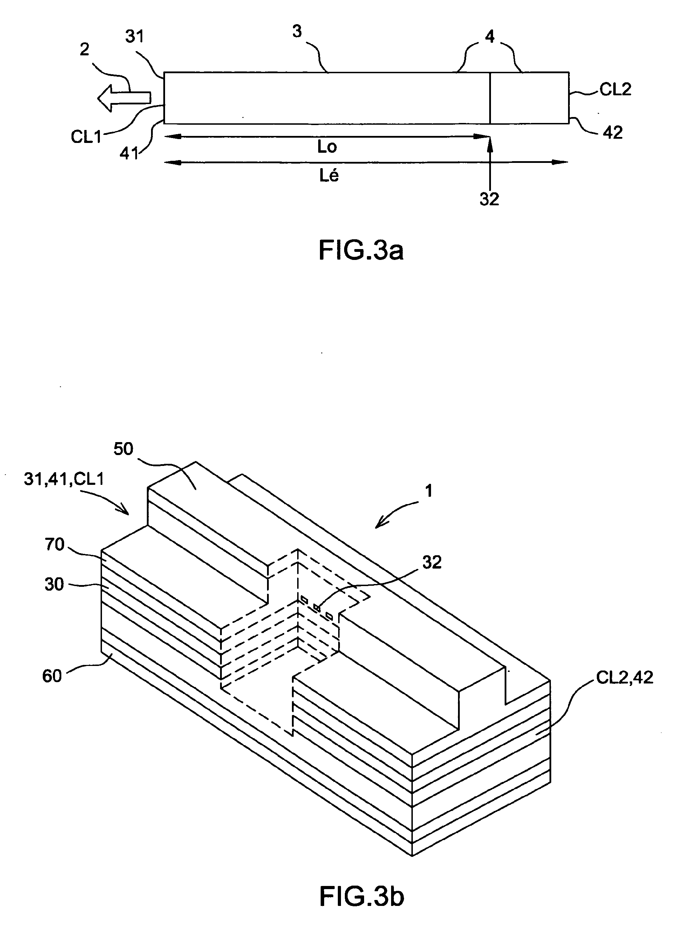

Sur les figures 3a, 4a et 5a, les cavités optique et électrique sont schématiquement représentées sous forme rectangulaire à l'aplomb de l'électrode d'alimentation en ruban, pour simplifier ; dans la réalité elles ont entre leurs réflecteurs respectifs la forme décrite en relation avec les figures 2.

Selon un premier mode de réalisation montré figures 3a et 3b, l'électrode 50 est rectiligne et a une longueur Lé supérieure à Lo.

Selon ce mode de réalisation, la cavité optique 3 est aussi rectiligne et est délimitée d'une part par la face clivée CL1 qui forme aussi un premier miroir optique 31, et d'autre part par un deuxième miroir optique 32 intégré dans le guide. Le deuxième miroir optique est par exemple un réseau de Bragg (comme montré sur la figure) ou une rangée de trous, ou un cristal photonique ; ce deuxième miroir optique 32 est transparent pour l'onde électrique.

La cavité électrique 4 associée à cette électrode rectiligne est donc aussi rectiligne. La longueur Lé de la cavité électrique est égale à celle de l'électrode dont les deux extrémités coïncident respectivement avec les deux faces clivées CL1 et CL2 du semi-conducteur et auxquelles correspondent les deux réflecteurs électriques 41, 42. Le deuxième réflecteur électrique 42 (la deuxième face clivée) est une facette réfléchissante pour l'onde électrique mais transparente pour le faisceau laser issu de la cavité optique 3 et qui se propage dans cette portion de cavité électrique non commune avec la cavité optique avant d'être émis au-delà de cette cavité électrique, en dehors du semi-conducteur.

La longueur Lé de la cavité électrique 4 c'est-à-dire celle de l'électrode 50 peut donc être adaptée indépendamment de celle de la cavité optique 3.

Les cavités optique et électrique ont une portion commune en l'occurrence égale à la cavité optique 3.

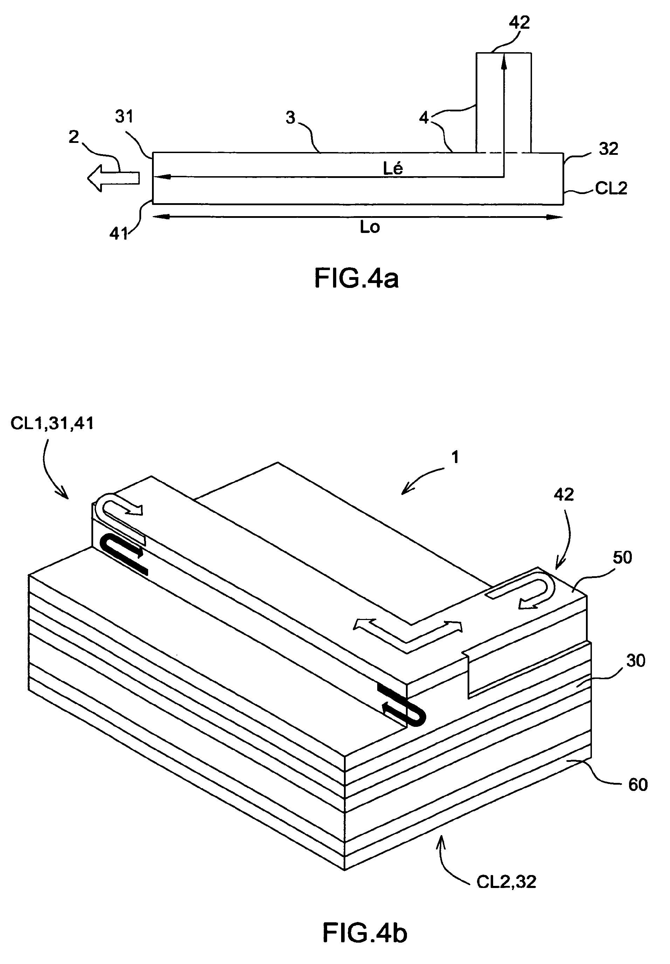

Selon un autre mode de réalisation montré figures 4a et 4b, l'électrode 50 est courbée dans le plan Oxy des couches que comporte le semi-conducteur : une extension latérale du ruban est ainsi formée. L'onde optique n'est pas capable de suivre l'angle qui est appliqué au ruban comme schématiquement illustré par les flèches grises. La cavité optique 3 est donc délimitée par les réflecteurs optiques que forment les deux faces clivées CL1, CL2. L'onde électrique est capable de suivre l'angle et sera réfléchie au bout de l'extension du ruban comme schématiquement illustré par les flèches blanches. La cavité électrique est ainsi délimitée par le premier réflecteur électrique 41 obtenu au niveau d'une des faces clivées CL1 d'un côté, et par le deuxième réflecteur électrique 42 obtenu par l'interruption de l'électrode en bout d'extension de l'autre côté. On peut obtenir une longueur physique de cavité électrique Lé supérieure à la longueur physique Lo de la cavité optique. Cette longueur Lé peut être adaptée par un choix judicieux de la longueur de l'extension.

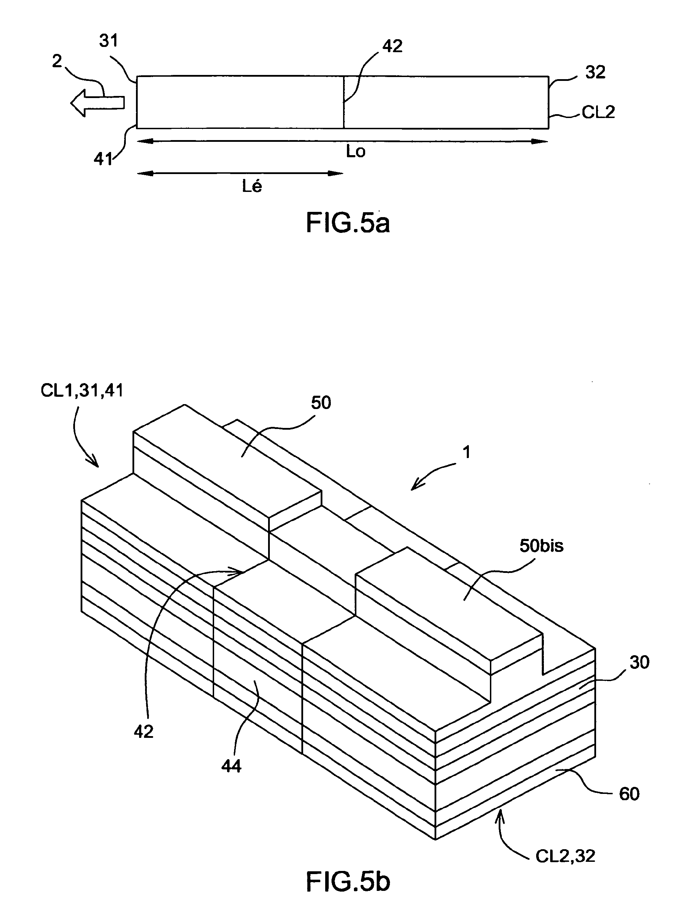

Selon un deuxième mode de réalisation montré figures 5, l'électrode 50 est rectiligne mais a une longueur Lé inférieure à Lo et déterminée de manière à avoir une fréquence de résonance correspondant à une harmonique de la cavité optique.

Selon ce mode de réalisation, la cavité optique 3 est aussi rectiligne et est délimitée d'une part par une face clivée CL1 qui tient lieu de premier miroir optique 31, et d'autre part par un deuxième miroir optique 32 qui est par exemple l'autre face clivée du semi-conducteur CL2 ou un miroir de Bragg ou tout réflecteur réalisable de manière monolithique dans la masse du semi-conducteur. La cavité optique comporte alors une portion sans électrode et donc non pompée. Il n'est en effet pas toujours nécessaire de pomper la cavité optique sur cette portion lorsque le milieu actif présente peu de pertes.

La cavité électrique 4 associée à cette électrode 50 rectiligne est donc aussi rectiligne. La longueur Lé de la cavité électrique est égale à celle de l'électrode 50 dont les deux extrémités coïncident respectivement avec la face clivée CL1 qui tient lieu de premier réflecteur électrique 41 et avec un deuxième réflecteur électrique 42 généré par l'autre extrémité de l'électrode, à l'aplomb de celle-ci. L'interruption de l'électrode associée au caractère isolant du matériau au-delà de l'électrode permet d'obtenir une différence d'impédance électrique pour l'onde électrique. Cette différence d'impédance permet de réfléchir l'onde électrique. Le deuxième réflecteur électrique 42 est ainsi une facette réfléchissante pour l'onde électrique mais transparente pour l'onde optique destinée à osciller dans toute la cavité optique.

La longueur de la cavité électrique c'est-à-dire celle de l'électrode peut donc être adaptée indépendamment de celle de la cavité optique.

Les cavités optique et électrique ont une portion commune en l'occurrence égale à la cavité électrique 4.

Selon une autre variante de ce mode de réalisation, une deuxième électrode 50 bis est positionnée sur la portion de cavité optique non couverte par la première électrode 50 (comme montré figure 5b) : ces deux électrodes sont électriquement distinctes et sont séparées par une zone isolante 44 éventuellement délimitée par les deux électrodes 50 et 50bis, mais qui peut être plus étroite. Cette deuxième électrode 50 bis assure alors une fonction de pompage de la portion de cavité optique correspondante, sans pour autant que le signal électrique délivré par cette électrode soit modulé à la fréquence de résonance de la cavité électrique qu'elle génère dite deuxième cavité électrique.

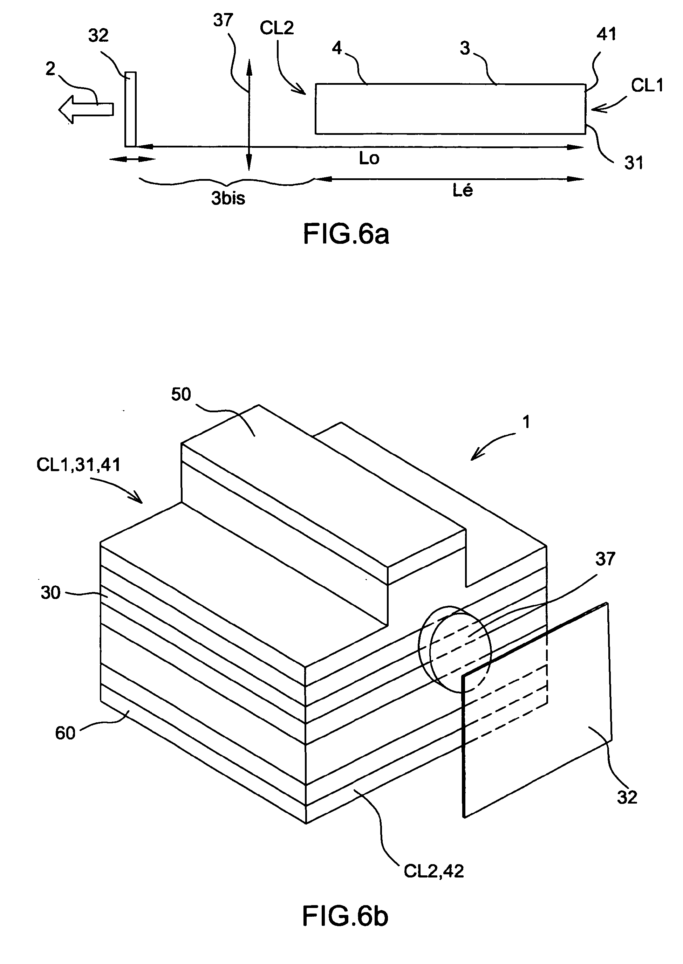

Selon une variante de réalisation de ce mode de réalisation montré figures 6, le deuxième miroir optique 32 est un miroir externe au semi-conducteur, aisé à déplacer ce qui permet d'adapter la longueur Lo de la cavité optique de manière à ce que la fréquence fondamentale d'oscillation de la cavité optique corresponde à une sous-harmonique de la fréquence imposée par la cavité électrique. Dans ce cas la face clivée CL2 du semi-conducteur a un traitement anti-réfléchissant pour ne pas avoir de fonction de miroir optique. Le miroir optique externe 32 est typiquement une lame de verre partiellement réfléchissante. Un dispositif optique 37 placé entre la facette traitée CL2 et la lame de verre 32 permet de collimater le faisceau émis par le semi-conducteur. La portion sans électrode de la cavité optique dite cavité optique externe 3 bis, n'est alors plus confinée dans le semi-conducteur.

La diode laser selon l'invention permet d'améliorer la réponse en modulation des diodes lasers à semi-conducteur en bande étroite avec une mise-en-oeuvre simple, intégrée dans les étapes technologiques déjà utilisées pour la fabrication de diodes lasers à semi-conducteur, et adaptée pour la modulation à haute fréquence comprise par exemple entre 10 et 100 GHz.

Des mesures préliminaires ont été réalisées sur un laser Fabry-Pérot de 1 mm avec Lé=Lo. Si les indices de groupe optique et électrique sont différents, la fréquence de résonance de la cavité optique $F_o$ doit être différente de la fréquence de résonance de la cavité électrique $F_é$. La résonance de la cavité optique $F_o$ mesurée est de 43 GHz et celle de la cavité électrique $F_é$ est de 47 GHz avec une amélioration du rendement de 15 dB. L'utilisation de la diode selon l'invention permet d'obtenir une égalité entre ces fréquences ou une de leurs harmoniques.

**Revendications**

1. Diode laser (1) à semi-conducteur à modulation électrique directe qui comprend une cavité optique (3) de longueur Lo et un circuit d'alimentation comportant une électrode (50) d'alimentation modulée de longueur Lé qui recouvre tout ou partie de la cavité optique (3), et qui contribue à délivrer un signal électrique de pompage de la cavité optique à une fréquence de modulation Fe, **caractérisée en ce qu'**elle comprend une cavité électrique (4) de longueur Lé associée à cette électrode (50), telle que $n_o.Lo = k.n_é.Lé$, k étant un entier positif ou l'inverse d'un entier positif, no étant l'indice de réfraction de la cavité optique et $n_é$ l'indice électrique de la cavité électrique, et **en ce que** Fe = c.k'/(2.né.Lé), c étant la vitesse de la lumière dans le vide, k' étant un entier supérieur ou égal à 1, et **en ce que** l'électrode est en forme de ruban.

2. Diode laser (1) à semi-conducteur selon la revendication précédente, **caractérisée en ce que** Lé < Lo.

3. Diode laser (1) à semi-conducteur selon la revendication 2, **caractérisée en ce que** la cavité optique (3) comprend une section externe (3bis) au semi-conducteur.

4. Diode laser (1) à semi-conducteur selon l'une des revendications 1 ou 2, **caractérisée en ce qu'**il comprend une deuxième électrode (50bis) d'alimentation non modulée, électriquement séparée de la première électrode (50), pour un pompage électrique de la section de cavité optique non pompée par la première électrode.

5. Diode laser (1) à semi-conducteur selon l'une des revendications précédentes, **caractérisée en ce que** les longueurs des cavités optique et électrique étant respectivement délimitées par deux miroirs optiques (31, 32) et deux réflecteurs électriques (41, 42), un miroir optique (31) et un réflecteur électrique (41) sont situés dans un même plan, l'autre miroir optique (32) et l'autre réflecteur électrique (42) étant situés dans des plans distincts.

6. Diode laser (1) à semi-conducteur selon l'une des revendications précédentes, **caractérisée en ce que** le semi-conducteur comprenant un empilement de couches planes selon Oxy, l'électrode (50) est courbée dans un plan parallèle au plan de ces couches.

**Claims**

1. A semi-conductor laser diode (1) with direct electrical modulation, comprising an optical cavity (3) of length Lo and a power supply circuit comprising a modulated power supply electrode (50) of length Lé which covers all or part of said optical cavity (3) and which assists in delivering an electrical pump signal of the optical cavity at a modulation frequency Fe, **characterised in that** it comprises an electrical cavity (4) of length Lé that is associated with said electrode (50), such that $n_o.Lo = k.n_é.Lé$, k being a positive integer or the inverse of a positive integer, $n_o$ being the refractive index of said optical cavity and $n_é$ being the electrical index of said electrical cavity, and **in that** $Fe = c.k'/(2n_é.Lé)$, c being the speed of light in the vacuum, k' being an integer that is greater than or equal to 1, and **in that** said electrode is in the form of a band.

2. The semi-conductor laser diode (1) according to the preceding claim, **characterised in that** Lé < Lo.

3. The semi-conductor laser diode (1) according to claim 2, **characterised in that** the optical cavity (3) comprises a section (3bis) that is outside of the semi-conductor.

4. The semi-conductor laser diode (1) according to any one of claims 1 or 2, **characterised in that** it comprises a second non-modulated power supply electrode (50bis) that is electrically separated from the first electrode (50) for electrically pumping the section of optical cavity that is not pumped by the first electrode.

5. The semi-conductor laser diode (1) according to any one of the preceding claims, **characterised in that**, as the lengths of the optical and electrical cavities are respectively bounded by two optical mirrors (31, 32) and two electrical reflectors (41, 42), an optical mirror (31) and an electrical reflector (41) are located in the same plane, the other optical mirror (32) and the other electrical reflector (42) being located in distinct planes.

6. The semi-conductor laser diode (1) according to any one of the preceding claims, **characterised in that** the semi-conductor comprises a stack of flat layers along Oxy, the electrode (50) is curved in a plane that is parallel to the plane of said layers.

**Patentansprüche**

1. Halbleiter-Laserdiode (1) mit direkter elektrischer Modulation, die einen optischen Resonator (3) mit einer Länge Lo und eine Stromversorgungsschaltung mit einer modulierten Stromversorgungselektrode (50) einer Länge Lé umfasst, die den optischen Resonator (3) ganz oder teilweise bedeckt und bei der Lieferung eines elektrischen Pumpsignals von dem optischen Resonator mit einer Modulationsfrequenz Fe assistiert, **dadurch gekennzeichnet, dass** sie eine elektrische Kavität (4) einer Länge Lé umfasst, die mit der Elektrode (50) assoziiert ist, so dass $n_o.Lo = k.n_é.Lé$, wobei k eine positive ganze Zahl oder die Umkehr einer positiven ganzen Zahl ist, wobei $n_o$ der Brechungskoeffizient der optischen Kavität und $n_é$ die elektrische Kennzahl der elektrischen Kavität ist, und **dadurch**, dass $Fe = c.k'/(2n_é.Lé)$, wobei c die Geschwindigkeit des Lichts im Vakuum ist, k' eine ganze Zahl gleich oder größer als 1 ist, und **dadurch**, dass die Elektrode die Form eines Bandes hat.

2. Halbleiter-Laserdiode (1) nach dem vorherigen Anspruch, **dadurch gekennzeichnet, dass** Lé < Lo.

3. Halbleiter-Laserdiode (1) nach Anspruch 2, **dadurch gekennzeichnet, dass** der optische Resonator (3) einen Abschnitt (3bis) außerhalb des Halbleiters aufweist.

4. Halbleiter-Laserdiode (1) nach Anspruch 1 oder 2, **dadurch gekennzeichnet, dass** sie eine zweite nichtmodulierte Stromversorgungselektrode (50bis) umfasst, die elektrisch von der ersten Elektrode (50) getrennt ist, um den von der ersten Elektrode nicht gepumpten Abschnitt des optischen Resonators elektrisch zu pumpen.

5. Halbleiter-Laserdiode (1) nach einem der vorherigen Ansprüche, **dadurch gekennzeichnet, dass** sich, da die Längen des optischen Resonators und der elektrischen Kavität jeweils durch zwei optische Spiegel (31, 32) und zwei elektrische Reflektoren (41, 42) begrenzt werden, ein optischer Spiegel (31) und ein elektrischer Reflektor (41) in derselben Ebene befinden, wobei sich der andere optische Spiegel (32) und der andere elektrische Reflektor (42) in verschiedenen Ebenen befinden.

6. Halbleiter-Laserdiode (1) nach einem der vorherigen Ansprüche, **dadurch gekennzeichnet, dass**, da der Halbleiter einen Stapel flache Schichten entlang Oxy umfasst, die Elektrode (50) in einer Ebene gekrümmt ist, die parallel zur Ebene der Schichten ist.

FIG.1

FIG.2a

FIG.2b

FIG.3a

FIG.3b

FIG.4a

FIG.4b

31
42
2
32
CL2
41
Lo
Lé

**FIG.5a**

CL1,31,41
50
1
50bis
42
30
44
60
CL2,32

**FIG.5b**

## FIG.6a

## FIG.6b

**EP 2 290 767 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **Maricot, S. ; Vilcot, J.P. ; Decoster, D. ; Renaud, J.C. ; Rondi, D. ; Hirtz, P. ; Blondeau, R. ; de Cremoux, B.** Monolithic integration of optoelectronic devices with reactive matching networks for microwave applications. *IEEE Photonics Technology Letters,* Novembre 1992, vol. 4 (11), 1248-1250
- **Goldsmith, C.L. ; Kanack, B.** Broad-band reactive matching of high-speed directly modulated laser diodes. *IEEE Microwave and Guided Wave Letters,* Septembre 1993, vol. 3 (9), 336-338

- **Nagarajan, R. ; Levy, S. ; Mar, A. ; Bowers, J.E.** *IEEE - PTL,* Janvier 1993, vol. 5 (1), 4-6
- **Lau, K.Y.** Narrow-band modulation of semiconductor lasers at millimeter wave frequencies (>100 GHz) by mode locking. *IEEE Journal of Quantum Electronics,* Février 1990, vol. 26 (2), 250-261